# EUROPEAN PATENT APPLICATION

(11) **EP 2 219 231 A1**
(43) Date of publication of application: **18.08.2010**
(21) Application number: 09305133.2
(22) Date of filing: 12.02.2009
(51) Int. Cl.: H01L 31/18, H01L 31/20, H01L 31/0336

(54) **Method and apparatus for irradiating a photovoltaic material surface by laser energy**

(71) Applicant: Excico France, 92230 Gennevilliers (FR)
(72) Inventor: Rack, Simon, 1340 Ottignies (BE)
(74) Representative: BiiP cvba

(57) **Abstract**

The present invention is related to method for manufacturing TF-PV material comprising:
- providing a TF-PV material layer having a degree of crystallinity, and
- irradiating a surface region of the TF-PV material layer by means of a laser source having irradiation parameters,

**characterized in that** the irradiation parameters are selected such that the degree of crystallinity is increased at least at a top layer of the surface region.

## Description

### FIELD OF THE INVENTION

The present invention relates to a method of irradiating a photovoltaic material surface by means of a laser.

### BACKGROUND OF THE INVENTION

As a low-cost, and therefore potentially commercially important alternative to conventional photovoltaic cells made from crystalline semiconductors, so-called 'thin-film' photovoltaic (TF-PV) cells have been developed. These TF-PV cells typically require about two orders of magnitude less semiconductor material for their fabrication compared to conventional photovoltaic cell made from bulk semiconductor material.

TF-PV cells comprise a variety of different cell designs, for example microcrystalline silicon (µc-Si:H) PV cells, amorphous/ microcrystalline silicon (a-Si:H/µc-Si:H) PV cells, and CIGS (copper indium gallium selenide) PV cells.

The major elements of a TF-PV cell consist of a stack of thin films on a glass or other suitable flexible or rigid substrate, the TF stack essentially comprising an absorber layer from semiconductor material or a stack of such layers sandwiched between a back electrode and a front electrode.

In the case of conventional silicon-based cells, changes in the degree of crystallinity (i.e. how well-ordered the material is on an atomic scale) of the absorber layers will influence both the cell open-circuit voltage and the optical absorption, thereby having an impact on the maximum possible energy conversion efficiency of the cell.

Especially with advanced silicon-based cells, which favour a multi-junction stacked design where junctions formed both in largely amorphous and in micro-crystalline silicon layers are included, close control of the degree of crystallinity of all the layers is of key importance in optimizing the cell performance.

Further, as an additional process step post-deposition heating of the thin films is generally required in order to produce the desired crystalline structure and for reducing the density of recombination centers at film interfaces. Since both the final composition of the thin film and its degree of crystallinity are crucially important, and liable to change on heating above certain threshold temperatures, post-deposition heating may results in degradation of the cell performance.

In an attempt to solve the above problems, incremental improvements in the deposition and the post-deposition heating steps and in the processing used have been proposed in the art.

In the present state of the art, both silicon-based and CIGS cells are generally manufactured in multi-chamber or single-chamber vacuum-PECVD (plasma enhanced chemical vapour deposition) equipment, or in multi-station vacuum co-evaporation equipment, wherein various parameters such as temperatures, RF excitation frequencies, RF power densities, feed-gas compositions, evaporation source designs etc. have been co-optimised, within the limits imposed by the overall system designs.

For silicon-based cells, large-scale complex and expensive machinery has been developed, based on established techniques such as PECVD, and successive layers are deposited in sequence in one or more dedicated chambers. Variants where a seed layer is initially deposited, upon which epitaxial growth processes are then performed have also been developed, although these are of similar complexity and generally require temperatures higher than can be tolerated by standard glass substrates.

Further, although multi-chamber systems have as primary advantage that individual chambers are only exposed to just one type of dopant in the precursor gas thereby reducing any unintentional doping of the intrinsic absorber layer by residual dopant remaining on the reactor walls and electrode surfaces from the previous doped-layer deposition steps, they suffer from the key disadvantage that these require appropriate modules and mechanisms for high-vacuum inter-chamber substrate transport, and are therefore generally of high cost and relatively low throughput.

Another problem specifically related to multi-chamber tools is that highly sensitive thin film interface layers are exposed during transport between chambers , such that these layers may react with residual oxygen causing a degradation of the interface properties or necessitating additional surface preparation steps prior to the next deposition step.

Single-chamber systems do not require the additional complexity of vacuum transfer hardware between chambers, but suffer from doping memory effects from one process step to the next. Avoidance of doping memory effects necessitates the inclusion of lengthy chamber cleaning and conditioning steps between deposition processes, steps to which the PV cell will also be subjected during fabrication.

Similar levels of cost and complexity are involved in the production of CIGS layers by the co-evaporation process, where very close control of temperatures, evaporation source effusion rates and ambient atmosphere conditions are required in order to maintain the desired film composition, while also forming the large, columnar grains required for good device performance. Selenium loss is a key problem as this element has a significantly higher vapour pressure than the other components, at elevated temperature.

Further, post-deposition heating of CIGS layers must generally be performed in a carefully balanced, selenium-rich ambient, adding complexity, cost and sources of variation to the overall process.

From the above, it is clear that the current deposition and post-deposition heating methods are both slow and costly, requiring either physical relocation of the substrate between successive deposition steps, or time-consuming and expensive chamber cleaning and conditioning operation between deposition steps. Further, these methods are difficult to control and expensive to operate.

Considering the drawbacks of the current TF-PV cell manufacturing methods, it is a primary object of the present invention to provide a simpler, more cost-effective and industrially suitable method for the production of TF-photovoltaic cells with CIGS or a-Si:H/pc-Si:H absorber layers.

It is a second object of the present invention to reduce the number of distinct deposition steps required in order to obtain the final desired absorber stack.

A further object is to provide a method which may result in improved TF absorber layers, resulting in better TF-PV cell performance.

It is another object of the present invention to decrease the complexity of CIGS deposition process, while maintaining low selenium-loss.

The present invention meets the above objects by irradiating a surface region of the TF-PV material layer by means of a laser source, such that the degree of crystallinity is increased at least at a top layer of that surface region.

### SUMMARY OF THE INVENTION

The present invention is directed to a method for manufacturing TF-PV material comprising:
- providing a TF-PV material layer having a degree of crystallinity, and
- irradiating a surface region of the TF-PV material layer by means of a laser source having irradiation parameters,
**characterized in that** the irradiation parameters are selected such that the degree of crystallinity is increased at least at a top layer of the surface region.

### DESCRIPTION OF THE INVENTION

A person skilled in the art will understood that the embodiments described below are merely illustrative in accordance with the present invention and not limiting the intended scope of the invention. Other embodiments may also be considered.

According to a first embodiment of the present invention a method for manufacturing TF-PV material is provided comprising:
- providing a TF-PV material layer having a degree of crystallinity, and
- irradiating a surface region of the TF-PV material layer by means of a laser source having irradiation parameters,
**characterized in that** the irradiation parameters are selected such that the degree of crystallinity is increased at least at a top layer of the surface region.

In accordance with the present invention, short-duration, localised heating by irradiation of different parts of the TF-PV cell structure by laser irradiation may be used to selectively modify physical, optical and electronic properties of the deposited thin-films, and thereby to improve the overall performance of the cells. In particular, changes to the crystalline, multicrystalline or amorphous structures present in different parts of the films may be brought about.

The laser radiation causes highly localized non-uniform heating of a portion of the thin-film to be processed. The surface and near-surface regions of the thin-film may be heated to temperatures above the melting temperature, while substantial portions of the film remain below the melting temperature. Among other thermal effects induced, the crystalline structure is modified. This modification may be largely confined to the melted region, or may extend into the non-melted region, depending on the choice of irradiation parameters and on the initial conditions of the substrate underneath the TF-PV material.

In accordance with the present invention, the irradiation step may involve exposure of partially completed TF-PV layers, in order to modify their structure throughout a top layer, i.e. a part of their thickness. This modification throughout a top layer may be performed such that a previously homogenous layer with a degree of crystallinity will be transformed into two or more distinguishable layers of which at least a top layer obtained a higher degree of crystallinity. This means that fewer layers need to be deposited by the conventional methods outlined above, resulting in lower costs and higher machine output for those steps. The cost and time savings for this can be very significant in specific commonly-encountered cases due to the different deposition rates achievable for films of different types. For example, a highly amorphous layer of a-Si:H can be deposited at a higher rate (i.e. in less time) than a micro-crystalline layer having the same thickness. Subsequent transformation of at least a top part of the amorphous layer into µC-Si:H can thus represent a significant cost and time saving in the deposition processes.

In an embodiment of the present invention, the laser source may be any laser whose wavelength, energy and pulse duration is adapted to the process, preferably an excimer laser and even more preferably a xenon chloride excimer laser.

Preferably the laser source may irradiate in near-UV, more preferably having a wavelength of 308 nm. Due to the strong absorption of the chosen wavelength, and the short duration of the treatment, high temperature processing of the films can be performed, while avoiding that the underlying substrate is significantly heated.

The laser irradiation may be pulsed laser irradiation, preferably having an aerial energy density of 0.2 to 3 J/cm² and delivered pulse energy of 1 to 50 Joules. Use of a high energy laser allows processing of large areas with each laser pulse.

The pulse duration may be between 50 to 250 nanoseconds.

The laser source may illuminate a rectangular region of the material surface having a major linear dimension of 10 mm to 1000 mm and a minor linear dimension of 0.05 mm to 100 mm.

In an embodiment in accordance with the present invention, a method is provided, wherein the irradiation parameters are selected such that explosive recrystallization occurs.

In the context of the present invention, explosive recrystallization is recrystallization in which a moving melt front propagates towards underlying material. Explosive recrystallization occurs when the molten material starts to solidify into crystalline material from the primary melt at the surface of the irradiated region. The latent heat released by this solidification melts a thin layer of the overlying material. Latent heat is again released during recrystallization of this secondary melt and thus a thin liquid material layer propagates from the original liquid-solid interface towards the underlying material.

In a preferred embodiment in accordance with the present invention, a method is provided, wherein the depth of the top layer of the surface region is greater than both the irradiation absorption depth and the non-explosive melting-front depth. The explosive recrystallisation effect is exploited to achieve partial recrystallisation at depths greatly exceeding both the optical absorption depth and the depth of the primary melting front in the treated layer. Since the deposition process for example for amorphous silicon can proceed at a substantially higher rate (preferably at least an order of magnitude faster) than for microcrystalline sillicon, this techniques for forming a combined microcrystalline/amorphous double-layer from a single layer permits significant cost and time savings in the deposition process.

In a preferred embodiment of the present invention, the TF-PV material layer consists of a layer stack comprising a stopping layer defining the depth of the top layer of the surface region. The stopping layer should have an enthalpy of fusion higher than the enthalpy of fusion of the to be recrystallized layer, which means that it may either have largely the same composition with a degree of crystallinity as high as necessary, - preferably 65 to 90% -, to provide a reliable quenching of the explosive recrystallization front, or have another composition, e.g. by adding dopants, O, N, metals, etc. thereby raising its heat of fusion. The stopping layer may have a layer thickness of about 5 to 75 nanometer.

The main advantage of using a stopping layer is that slow deposition of a thick microcrystalline layer may be avoided by faster deposition of an amorphous layer on top of the stopping layer and recrystallizing it.

The step of irradiating the TF-PV material layer may be performed in ambient atmosphere, but in an alternative embodiment of the present invention, the method may further comprise providing an encapsulation layer, such as SOG (Spin on Glass), on the surface region of the TF-PV material layer before irradiation. Due to the different absorption characteristics of different materials, selective heating of certain layers can be achieved while those layers are covered by encapsulating material.

The presence of the encapsulating layer(s) serves to reduce the loss of the more volatile constituents (i.e. selenium) of the underlying layers, and may effectively extend the heating time of the underlying structure while also reducing the peak temperature to which it is exposed.

Further the encapsulating layer may provide a thermal reservoir for conductive heating of underlying layers on a timescale greater than the pulse duration itself, and at a lower peak temperature than that to which the surface layers are subjected.

Further, it may act as an optical element to enhance the coupling of the laser energy with the irradiated TF-PV layer.

Fabrication of TF PV cells is based on a sequence of deposition and patterning steps, which generally include at least the following:
The TF-PV material layer may be of any material suitable for thin film photovoltaic applications such as, but not limited to undoped silicon, doped silicon, implanted silicon, crystalline silicon, amorphous silicon, silicon germanium, germanium nitride, III-V compound photovoltaics such as gallium nitride, silicon carbide, and the like.

The method in accordance with the present invention may be used for making TF photovoltaic material or devices, such as but not limited to silicon based TF-PV cells and CIGS cells.

The method may be applied as illustrated in a number of examples:

### Example 1:

a) Deposition of a TF absorber film comprising at least one amorphous silicon layer, followed by
b) Partial recrystallization of the amorphous silicon layer to produce a stack with distinct amorphous silicon/ micro-crystalline layers, whereby the explosive recrystallisation effect is used to achieve recrystallisation at a depth greatly exceeding irradiation absorption depth.

### Example 2:

a) Application of a TCO (Transparant Conductive) layer (e.g. Sputtered ZnO) onto a TF absorber layer comprising at least one amorphous silicon layer, followed by
b) Partial recrystallization of the amorphous silicon layer to produce a stack with distinct amorphous silicon/ micro-crystalline layers, whereby the explosive recrystallisation effect is used to achieve recrystallisation at a depth greatly exceeding both the irradiation absorption depth and the non-explosive melting-front depth, while
c) Simultaneously heating the overlying TCO layer during the irradiation step to improve the optical and electrical characteristics of the TCO film and to enhance, i.e. to reduce the resistance of the TCO-semiconductor contacts.

### Example 3:

a) Chemical bath deposition of a CdS (cadmium sulfide) buffer on top of a co-evaporated CIGS structure, followed by application of an SOG encapsulating layer,
b) Laser irradiation resulting in improved crystallinity of the CdS layer and in beneficial annealing of the CIGS layer, without loss of selenium, followed by
c) Selective removal of the SOG layer.

### Example 4:

A conventional PECVD deposition sequence as follows:
- deposition of p/i/n 3-layer 300 nm amorphous stack, followed by
- deposition of p/i/n 3-layer 2 micron microcrystalline stack with 45-75% crystallinity
   is replaced in accordance with the present invention by:

- deposition of p/i/n 3-layer 300 nm amorphous stack, followed by
- deposition of 50 nm microcrystalline stopping layer with 65-90% crystallinity, followed by
- deposition of 2 micron amorphous layer with 0-50% crystallinity, followed by
- recrystallization of the 2 micron amorphous silicon layer.

The 2 micron amorphous layer can be deposited fast, either in the form of a p/i/n stack, either in the form of a p/i-stack, which is then n-doped by the same laser anneal which will cause explosive recrystallization.

## Claims

1. A method for manufacturing TF-PV material comprising:
- providing a TF-PV material layer having a degree of crystallinity, and
- irradiating a surface region of the TF-PV material layer by means of a laser source having irradiation parameters,
**characterized in that** the irradiation parameters are selected such that the degree of crystallinity is increased at least at a top layer of the surface region.

2. A method according to claim 1, wherein the laser source irradiates in near-UV.

3. A method according to claim 1 or 2, wherein the irradiation parameters are selected such that explosive recrystallization occurs.

4. A method according to claim 3, wherein the depth of the top layer is greater than both the irradiation absorption depth and the non-explosive melting-front depth.

5. A method according to claims 1 to 4 further comprising providing an encapsulation layer on the surface region of the TF-PV material layer before irradiation.

6. A method according to claims 1 to 5, wherein the TF-PV material layer consists of a layer stack comprising a stopping layer defining the depth of the top layer.

7. Use of a method according to any of the preceding claims in the manufacturing of CIGS cells.
